# EUROPEAN PATENT APPLICATION

(11) **EP 3 564 988 A1**
(43) Date of publication of application: **06.11.2019**
(21) Application number: 17885508.6
(22) Date of filing: 08.12.2017
(51) Int. Cl.: H01L 23/14, H01L 23/373, H01L 23/498, H01L 21/48

(54) **HEAT-DISSIPATING SUBSTRATE, PREPARATION METHOD AND APPLICATION THEREOF, AND ELECTRONIC COMPONENT**

(30) Priority: 29.12.2016 CN 201611249655
(71) Applicant: BYD Company Limited, Shenzhen, Guangdong 518118 (CN)
(72) Inventor: LIAN, Junlan, Shenzhen Guangdong 518118 (CN); XIONG, Yijing, Shenzhen Guangdong 518118 (CN); LIN, Hongye, Shenzhen Guangdong 518118 (CN)
(74) Representative: Gulde & Partner
(86) International application number: PCT/CN2017/115139
(87) International publication number: WO 2018/121216

(57) **Abstract**

This disclosure relates to the field of heat dissipation substrates for encapsulating electronic devices, and discloses a heat dissipation substrate, a method for preparing same, an application of same, and an electronic device. The heat dissipation substrate includes: a metal-ceramic composite board, where the metal-ceramic composite board is a metal layer wrapping a ceramic body; a metal oxide layer integrated with the metal layer and formed on an outer surface of the metal layer; and a soldering metal layer formed on at least a part of an outer surface of the metal oxide layer, where the soldering metal layer is used to connect with a copper substrate and bear a chip.

## Description

### CROSS-REFERENCE TO RELATED APPLICATIONS

This application claims priority to and benefits of Chinese Patent Application No. 201611249655.8, filed with the State Intellectual Property Office of P. R. China on December 29, 2016. The entire content of the above-referenced application is incorporated herein by reference.

### FIELD

This disclosure relates to the field of heat dissipation substrates for encapsulating electronic devices, and specifically, to a heat dissipation substrate, a method for preparing same, an application of same, and an electronic device.

### BACKGROUND

In a process of preparing an electronic device, an encapsulating material usually needs to be used to resolve a thermal failure problem of an electronic circuit such as a chip. The encapsulating material not only needs to play a role of being capable of soldering a copper substrate and bearing a chip, but also needs to be responsible for heat dissipation at the same time. Because the encapsulating material is in contact with a cooling liquid in a process of performing heat exchange, the encapsulating material is further required to have anticorrosion performance.

Therefore, during actual use, the encapsulating material is usually applied in a substrate form, and it is required that a surface of the substrate is used for soldering the copper substrate and bearing the chip, and can have a soldering function; and another opposite surface is in contact with the cooling liquid to implement heat dissipation, and can have an anticorrosion function. To satisfy this requirement, a current usual solution is to perform nickel plating on the entire substrate. However, this imposes a strict requirement on quality of a surface of the substrate. If there are a pit, a sand hole, and the like, nickel plating cannot cover up these defects. As a result, a soldering yield rate is low. Although the thickness of a plating layer may be increased through design of a plating layer structure, production costs are increased evidently.

In the prior art, in the process of preparing an electronic device, a nickel plating method is taken to resolve the heat dissipation problem and the anticorrosion problem of the encapsulating material. However, there are defects that the product yield rate is low and costs are high.

### SUMMARY

An objective of this disclosure is to resolve the foregoing problem existing in a heat dissipation substrate used for encapsulating an electronic device, so as to provide a heat dissipation substrate, a method for preparing same, an application of same, and an electronic device.

In order to achieve the foregoing objective, this disclosure provides a heat dissipation substrate, where the heat dissipation substrate includes: a metal-ceramic composite board, where the metal-ceramic composite board is a metal layer wrapping a ceramic body; a metal oxide layer integrated with the metal layer and formed on an outer surface of the metal layer; and a soldering metal layer formed on at least a part of an outer surface of the metal oxide layer, where the soldering metal layer is used to connect with a copper substrate and bear a chip.

This disclosure further provides a method for preparing a heat dissipation substrate of this disclosure, including: directly performing metal oxidation on a metal-ceramic composite board, where the metal-ceramic composite board is a composite board material in which a metal layer wraps a ceramic body; forming a metal oxide layer integrated with the metal layer on an outer surface of the metal layer; and performing metal spraying on at least a part of an outer surface of the metal oxide layer, to form a soldering metal layer.

This disclosure further provides an application of a heat dissipation substrate of this disclosure in an electronic device.

This disclosure further provides an electronic device, where the electronic device includes: a heat dissipation substrate, where the heat dissipation substrate has a soldering metal layer; and a first soldering layer, a first copper substrate, a lining board, a second copper substrate, a second soldering layer, and a chip sequentially stacked on a surface of the soldering metal layer, where the chip is connected to the second copper substrate through a conducting wire; and the heat dissipation substrate is a heat dissipation substrate of this disclosure.

Through the foregoing technical solutions, direct oxidation is performed on the outer surface of the metal layer of the metal-ceramic composite board in situ to form the metal oxide layer, the dissipation substrate having heat dissipation, anticorrosion, and soldering functions may be provided, and the heat dissipation substrate has a larger bonding strength, and may better bear the chip, so as to overcome the defects of the nickel plating method taken in the prior art. the foregoing technical solutions, the obtained heat dissipation substrate may be provided with better soldering performance. That is, through a sessile drop test, the heat dissipation substrate has better wetting performance. Moreover, the provided heat dissipation substrate has better anticorrosion performance through a neutral salt spray test.

Other features and advantages of the disclosure are described in detail in the subsequent specific implementations.

### BRIEF DESCRIPTION OF THE DRAWINGS

The accompanying drawing is used to further understand the disclosure and constitute a part of the specification, and is used to explain the disclosure together with the following specific implementations, but does not constitute a limitation on the disclosure. In the accompanying drawings:
- FIG. 1: is a schematic structural diagram of a heat dissipation substrate;
- FIG. 2: is a schematic structural diagram of an electronic device; and
- FIG. 3: is a schematic diagram of a contact angle θ in a sessile drop test.

### Description of the reference signs:

| | | | | | |
|---|---|---|---|---|---|
| 1 | metal-ceramic composite board | 2 | metal oxide layer | 3 | soldering metal layer |
| 4 | first soldering layer | 5 | first copper substrate | 6 | lining board |
| 7 | second copper substrate | 8 | second soldering layer | 9 | chip |
| 10 | conducting wire | | | | |

### DETAILED DESCRIPTION

Specific implementations of the disclosure are described in detail below. It should be understood that the specific implementations described herein are merely used to describe and explain this disclosure rather than limit this disclosure.

Endpoints of all ranges and all values disclosed herein are not limited to the precise ranges or values, and these ranges or values should be understood as including values close to these ranges or values. For value ranges, endpoint values of the ranges, an endpoint value of each range and an independent point value, and independent point values may be combined with other to obtain one or more new value ranges, and these value ranges should be considered as being specifically disclosed herein.

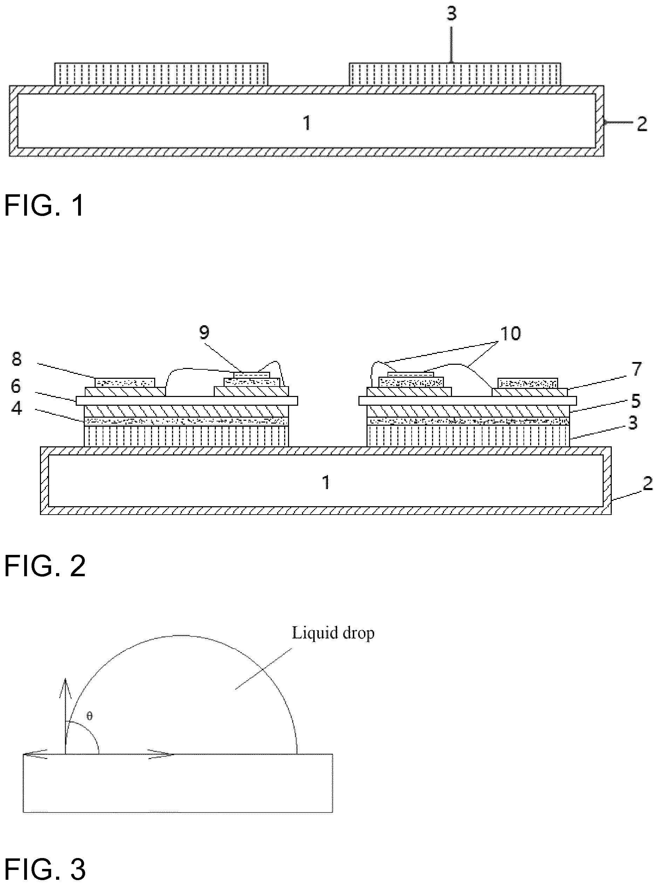

A first objective of this disclosure is to provide a heat dissipation substrate, as shown in FIG. 1. The heat dissipation substrate includes: a metal-ceramic composite board 1, where the metal-ceramic composite board is a metal layer wrapping a ceramic body; a metal oxide layer 2 integrated with the metal layer and formed on an outer surface of the metal layer; and a soldering metal layer 3 formed on at least a part of an outer surface of the metal oxide layer, where the soldering metal layer 3 is used to connect with a copper substrate and bear a chip.

According to this disclosure, the metal oxide layer is formed by directly oxidizing the metal layer, to wrap the metal layer. The metal oxide layer is formed by directly oxidizing the metal layer in situ, and may have a larger bonding strength. Photographing and observation may be performed through a metallographic microscope, and it is observed on a section of the heat dissipation substrate provided in this disclosure that there is no boundary between the metal layer of the metal-ceramic composite board and the metal oxide layer. However, if a metal oxide layer is obtained by coating or depositing a metal layer and then oxidizing the metal layer, it is observed through the metallographic microscope that an evident boundary exists between the metal layer of the metal-ceramic composite board and the formed metal oxide layer. Further, the metal oxide layer may be provided with a soldering surface (or surface A) and a heat dissipation surface (or surface B). The soldering surface (or surface A) and the heat dissipation surface (or surface B) may be two opposite surfaces on the heat dissipation substrate, and are usually two surfaces on the heat dissipation substrate that have maximum areas. The soldering metal layer is disposed on only the soldering surface and may be further used to solder the copper substrate and the chip. The heat dissipation surface may be in contact with a cooling liquid and is used for heat dissipation. Optionally, the soldering metal layer is disposed on the metal oxide layer on a side of the heat dissipation substrate; and the metal oxide layer on another side is used to be in contact with the cooling liquid, to perform heat dissipation.

In this disclosure, optionally, on the soldering surface, the soldering metal layer partially covers the metal oxide layer. Coverage distribution of the soldering metal layer on the metal oxide layer only needs to satisfy further soldering between the copper substrate and the chip.

The heat dissipation substrate provided in this disclosure may have better bonding strength, soldering performance, and anticorrosion performance through the foregoing metal oxide layer formed in situ.

According to this disclosure, for the heat dissipation substrate, a substrate material regularly used in an encapsulating material of an electronic device, for example, a base material containing metal may be selected as a base material, and the metal-ceramic composite board may be preferably selected as a base material. Then, the metal oxide layer and the soldering metal layer are formed on this base material. Optionally, the ceramic body is selected from a SiC ceramic body or a Si ceramic body; and the metal layer is an Al metal layer, an Mg metal layer, or a Ti metal layer. The metal-ceramic composite board may be commercially available. The thickness of the ceramic body may be not particularly limited, and may be approximately 3 mm.

According to this disclosure, the metal oxide layer is formed by the metal layer in situ, and the metal oxide layer is an oxide corresponding to metal used for the metal layer. The metal oxide layer is an aluminum oxide layer, a magnesium oxide layer, or a titanium oxide layer.

According to this disclosure, the soldering metal layer may be formed by selecting regularly used metal that may be used for soldering. Optionally, the soldering metal layer is a copper metal layer or a nickel metal layer.

According to this disclosure, it is only required that the thickness of each layer included in the heat dissipation substrate can implement the heat dissipation function, the anticorrosion function, and the functions of connecting to the copper substrate and bearing the chip. Optionally, the thickness of the metal layer is 20 µm to 500 µm; the thickness of the metal oxide layer is 5 µm to 300 µm; and the thickness of the soldering metal layer is 20 µm to 1000 µm. In this disclosure, the thickness of the metal oxide layer is less than the thickness of the metal layer.

According to this disclosure, the metal layer and the metal oxide layer in the heat dissipation substrate may have better bonding strength between each other. Optionally, the bonding strength between the metal oxide layer and the metal layer is measured to be above 4B according to a cross-cut test.

A second objective of this disclosure is to provide a method for preparing a heat dissipation substrate of this disclosure, including: directly performing metal oxidation on a metal-ceramic composite board, where the metal-ceramic composite board is a composite board material in which a metal layer wraps a ceramic body; forming a metal oxide layer integrated with the metal layer on an outer surface of the metal layer; and performing metal spraying on at least a part of outer surface of the metal oxide layer, to form a soldering metal layer.

According to this disclosure, a conventional material applicable to encapsulation of an electronic device may be selected, and may be a material containing metal. For example, the metal-ceramic composite board may be used as a base material for forming the heat dissipation substrate. The ceramic body may be selected from a SiC ceramic body or a Si ceramic body; and the metal layer may be selected from an Al metal layer, an Mg metal layer, or a Ti metal layer. The thickness of the ceramic body may be not particularly limited, and may be approximately 3 mm. The thickness of the metal layer may be 20 µm to 500 µm. Further, the metal oxide layer may be directly formed in situ on the outer surface of the metal layer in the metal-ceramic composite board through the metal oxidation. If the metal layer is an Al metal layer, an aluminum oxide layer is obtained. If the metal layer is an Mg metal layer, a magnesium oxide layer is obtained. If the metal layer is a Ti metal layer, a titanium oxide layer is obtained.

According to this disclosure, the metal oxidation may include a plurality of specific implementation methods, as long as a metal oxide layer satisfying a required thickness is formed on the outer surface of the metal layer in the metal-ceramic composite board. Optionally, a method for the metal oxidation includes chemical oxidation, anodic oxidation, micro-arc oxidation, or phosphatization. It is only required that the metal oxidation is implemented to obtain the metal oxide layer having a sufficient thickness. Optionally, the thickness of the metal oxide layer formed through the metal oxidation is 5 µm to 300 µm.

Specifically, a method and a condition for chemical oxidation include: removing surface oil contamination and a surface oxide layer from the metal-ceramic composite board, and then placing the metal-ceramic composite board in a chemical oxidation solution for 5 min to 10 min. The chemical oxidation solution contains 50 ml/L to 80 ml/L of phosphoric acid, and 20 g/L to 25 g/L of chromic anhydride (chromium trioxide). The temperature of the chemical oxidation solution is 30°C to 40°C.

A method and a condition for anodic oxidation include: removing surface oil contamination and a surface oxide layer from the metal-ceramic composite board, then placing the metal-ceramic composite board in a chemical oxidation solution, and electrifying the chemical oxidation solution for 10 min to 30 min to perform sealing treatment. The sealing treatment may be performed by using hot water. The oxidation solution is a solution containing 180 g/L to 220 g/L of sulfuric acid, the temperature is -5°C to 25°C, the voltage is 10 V to 22 V, and the current density is 0.5 A/dm² to 2.5 A/dm².

A method and a condition for micro-arc oxidation include: removing surface oil contamination the metal-ceramic composite board, then placing the metal-ceramic composite board in a micro-arc oxidation solution in a micro-arc oxidation tank, electrifying the micro-arc oxidation solution to perform micro-arc oxidation, and performing hot water sealing after micro-arc is completed. The micro-arc oxidation solution is usually a weakly basic solution, and may a silicate, a phosphate, a borate, or the like. The temperature of micro-arc oxidation is controlled to be 20°C to 60°C, and the voltage may be usually controlled to be 400 V to 750 V. The oxidation may alternatively be implemented by using a low-voltage micro-arc oxidation technology.

A method and a condition for phosphatization include: removing surface oil contamination from the metal-ceramic composite board, performing surface treatment for 5 min by using a surface modifier whose model is PL-Z (Guangzhou Pakerizing Co., Ltd.), performing phosphatization for 5 min by using a phosphatizing agent FT-7 (Guangzhou Pakerizing Co., Ltd.), and performing drying.

According to this disclosure, the metal spraying is used to form the soldering metal layer. As described above, the soldering metal layer may be formed in a partial area on a side surface of the heat dissipation substrate, and is used to further solder the copper substrate and the chip. Optionally, a method for the metal spraying includes: cold spraying, plasma spraying, flame spraying, or sputtering. It is only required that the metal spraying is implemented to obtain the soldering metal layer having a sufficient thickness and required distribution. Optionally, the thickness of the soldering metal layer formed through the metal spraying is 20 µm to 1000 µm.

Specifically, a method and a condition for cold spraying include: removing oil contamination from a surface of the formed metal oxide layer, then performing borax treatment, and then entering a cold spraying procedure, where gas is nitrogen gas and/or helium gas; the cold spraying pressure is 1.5 MPa to 3.5 MPa; the spraying distance is 10 mm to 50 mm; and the particle feed rate is 3 kg/h to 15 kg/h. Spraying is performed through the cold spraying to form metal of the soldering metal layer, such as copper or nickel, the metal is of a powder shape, and the average particle diameter is 1 µm to 50 µm. The metal may be commercially available, such as copper powder of 37 µm of a model TITD-Q Cu commercially available from Tianjiu Metal Material Co., Ltd. The particle feed rate is a rate of forming the metal of the soldering metal layer through spraying when the cold spraying is performed.

In this disclosure, when the metal spraying is performed, a part on the metal oxide layer that does not need to be sprayed may be protected by using a masking method.

In this disclosure, the foregoing preparation method may further include: first pre-treating the metal-ceramic composite board, degreasing and dewaxing the metal-ceramic composite board, further removing the oxide layer formed on the outer surface of the metal layer of the metal-ceramic composite board due to natural oxidation, and then performing the metal oxidation in the foregoing preparation method provided in this disclosure. For example, degreasing and dewaxing may be performed by immersing the metal-ceramic composite board in an ethyl solution for 5 min, or immersing the metal-ceramic composite board in degreasing powder U-151 (Atotech) for 5 min at 50°C. A method and a condition for removing the oxide layer formed due to natural oxidation may be: immersing the metal-ceramic composite board for 3 min in an aqueous sodium hydroxide solution whose concentration is 50 g/L, or immersing the metal-ceramic composite board for 1 min at a room temperature in a tank liquid configured by hot-dipping electrolytic deterging powder U-152.

In this disclosure, the foregoing preparation method may further include: after the metal oxidation step is completed, sealing and drying the obtained board material, and then performing the metal spraying. The function of sealing may be to seal holes formed during oxidation. Sealing may be implemented by using a boiling water sealing method. Drying may be performed for 20 min to 30 min at 80°C to 100°C.

A third objective of this disclosure is to provide an application of a heat dissipation substrate of this disclosure in an electronic device. The heat dissipation substrate of this disclosure may be used as an encapsulating material in an electronic device.

A fourth objective of this disclosure is to provide an electronic device. As shown in FIG. 2, the electronic device includes: a heat dissipation substrate 1, where the heat dissipation substrate has a soldering metal layer 3; and a first soldering layer 4, a first copper substrate 5, a lining board 6, a second copper substrate 7, a second soldering layer 8, and a chip 9 sequentially stacked on a surface of the soldering metal layer, where the chip is connected to the second copper substrate 7 through a conducting wire 10; and the heat dissipation substrate is a heat dissipation substrate of this disclosure. The heat dissipation substrate includes: a metal-ceramic composite board in which a metal layer wraps a ceramic body; a metal oxide layer integrated with the metal layer and formed on an outer surface of the metal layer; and the soldering metal layer formed on at least a part of an outer surface of the metal oxide layer.

In the electronic device of this disclosure, the heat dissipation substrate provides functions of bearing the chip and dissipating heat of the chip. A side of the heat dissipation substrate on the soldering metal layer is formed is further provided with a plurality of stacked layers, to bear chip; and another opposite side does not have the soldering metal layer, may be in contact with a cooling liquid, and is used as a cooling surface to dissipate heat of the chip. Because the cooling liquid is corrosive, and the cooling surface of the heat dissipation substrate has the metal oxide layer formed in situ by directly oxidizing the metal layer, an anticorrosion function may be provided.

In this disclosure, layers are sequentially stacked on the soldering metal layer, to finally bear the chip. The first soldering layer is used to connect the first copper substrate to the soldering metal layer. The first soldering layer may be formed through a tin soldering method by using a tin paste. The second soldering layer is used to connect the second copper substrate to the chip. The second soldering layer may also be formed through a tin soldering method by using a tin paste.

In this disclosure, the first copper substrate and the second copper substrate are copper substrates regularly used in the art. The second copper substrate may form a conductive trace, and then the chip and the second copper substrate are connected through the conducting wire, to satisfy a use requirement of the chip.

In this disclosure, the lining board is disposed between the first copper substrate and the second copper substrate, and may be a lining board used to encapsulate the electronic device and regularly used in the art.

In the electronic device of this disclosure, a method for forming the first soldering layer, the first copper substrate, the lining board, the second copper substrate, and the second soldering layer may be a regular method in the art, and details are not described herein again. The conducting wire may also connect the chip and the second copper substrate by using a regular method in the art, and details are not described herein again.

The disclosure is described in detail below by using embodiments.

In the following embodiments and comparison examples, a metal-ceramic composite board is an Al-SiC composite board from HWT Technology Co., Ltd.

Soldering performance passes through a sessile drop (Sessile Drop) test: A melted solder liquid dripped onto a surface of a soldering metal layer of a clean and smooth heat dissipation and after a balanced and stable state is reached, photographing is performed as shown in FIG. A photograph is enlarged, a contact angle θ is directly measured, and a corresponding interfacial tension is calculated through the angle θ. The contact angle θ in the method may be used to represent whether wetting is qualified: if θ<90°, it is referred to as wetting; if θ>90°, it is referred to as non-wetting; if θ=0°, it is referred to as complete wetting; and if θ=180°, it is to as complete non-wetting. Wetting represents good soldering performance, and is indicated by using "OK"; and non-wetting represents poor soldering performance.

Anticorrosion performance of the heat dissipation substrate passes through a neutral salt spray test: The heat dissipation substrate is inclined by 15° to 30°, so that a to-be-tested surface can accept salt spray at the same time; conditions are (5±0.1)% NaCl solution; the pH value is between 6.5 to 7.2; the salt spray settling amount is 1 to 2 ml/80 cm²•h; and the temperature is 35±2°C. The surface of the tested sample is observed, and time points at which bubbling and rusting occur are recorded.

The bonding strength between a metal oxide layer and a metal-ceramic composite board of a heat dissipation substrate in the embodiments, and the bonding strength between a nickel layer and a metal-ceramic composite board of a heat dissipation substrate in the comparison examples are tested according to GB/T 8642-2002.

The bonding strength between a metal oxide layer and a metal-ceramic composite board of a heat dissipation substrate in the embodiments, and the bonding strength between a nickel layer and a metal-ceramic composite board of a heat dissipation substrate in the comparison examples are measured according to a cross-cut test: 100 square grids of 1 mm×1 mm are cut, by using a cross-cutter, on a surface of a heat dissipation substrate on which a neutral salt spray test is performed for 24h. A transparent adhesive tape of a model 600 produced by USA 3M Corporation is used to smoothly bond the square grids without any void, and then is lifted up at a highest speed by an angle of 60°, to observe whether metal shedding exists at a scratch edge and score. Scoring standards are: if there is no shedding, the score is 5B; if the shedding amount is between 0 to 5 wt%, the score is 4B; if the shedding amount is between 5 to 15 wt%, the score is 3B; if the shedding amount is between 15 to 35 wt%, the score is 2B; if the shedding amount is between 35 to 65 wt%, the score is 1B; and if the shedding amount is above 65 wt%, the score is Embodiment 1

This embodiment describes a heat dissipation substrate of this disclosure.

An Al-SiC composite board (the thickness of SiC is 3 mm, and the thickness of Al is 200 µm) is immersed for 5 min in degreasing powder U-151 (Atotech) at 50°C to perform degreasing and dewaxing, and then immersed for 1 min at a room temperature in a tank liquid configured by hot-dipping electrolytic deterging powder U-152 to perform deoxidation, to obtain a to-be-oxidized substrate.

The to-be-oxidized substrate is placed in an oxidation solution containing 200 g/L of sulfuric acid (98 wt%), and anodic oxidation is performed for 20 min at 15°C, 10 V, and 2.5 A/cm³; an oxide layer whose thickness is 100 µm is obtained; then sealing is performed with purified water for 5 min at 95°C, and then for 30 min at 80°C; and a to-be-sprayed substrate is obtained.

A surface of the to-be-sprayed substrate is determined as a soldering surface, a part on which the soldering metal layer is not sprayed is masked, and then cold spraying of copper is performed: nitrogen gas, the pressure is 2.5 MPa, the spraying distance is 30 mm, and the copper powder feed (TITD-Q Cu) rate is 10 kg/h, to obtain the soldering metal layer whose thickness is 20 µm. The heat dissipation substrate is obtained.

Tests of soldering performance, anticorrosion performance, and bonding performance are performed on the heat dissipation substrate, and results are seen in Table 2.

### Embodiment 2

This embodiment describes a heat dissipation substrate of this disclosure and a method for preparing same.

An Al-SiC composite board (the thickness of SiC is 3 mm, and the thickness of Al is 100 µm) is immersed in ethyl alcohol for 5 min to perform degreasing and dewaxing, and then immersed in 50 g/L of aqueous sodium hydroxide solution for 3 min, to obtain a to-be-oxidized substrate.

The to-be-oxidized substrate is placed in an oxidation solution containing 180 g/L of sulfuric acid (98 wt%), and anodic oxidation is performed for 30 min at -5°C, 22 V, and 1 A/cm³; an aluminum oxide layer whose thickness is 30 µm is obtained; then sealing is performed with purified water for 5 min at 95°C, and then for 30 min at 80°C; and a to-be-sprayed substrate is obtained.

A surface of the to-be-sprayed substrate is determined as a soldering surface, a part on which the soldering metal layer is not sprayed is masked, and then cold spraying of copper is performed: nitrogen gas, the pressure is 3 MPa, the spraying distance is 40 mm, and the copper powder feed rate is 10 kg/h, to obtain the soldering metal layer whose thickness is 50 µm. The heat dissipation substrate is obtained.

Tests of soldering performance, anticorrosion performance, and bonding performance are performed on the heat dissipation substrate, and results are seen in Table 2.

### Embodiment 3

This embodiment describes a heat dissipation substrate of this disclosure and a method for preparing same.

An Al-SiC composite board (the thickness of SiC is 3 mm, and the thickness of Al is 50 µm) is immersed for 5 min in degreasing powder U-151 (Atotech) at 50°C to perform degreasing and dewaxing, and then immersed for 1 min at a room temperature in a tank liquid configured by hot-dipping electrolytic deterging powder U-152 to perform deoxidation, to obtain a substrate.

The to-be-oxidized substrate is placed in an oxidation solution containing 200 g/L of sulfuric acid (98 wt%), and anodic oxidation is performed for 10 min at 25°C, 18 V, and 0.5 A/cm³; an aluminum oxide layer whose thickness is 5 µm is obtained; then sealing is performed with purified water for 5 min at 95°C, and then for 30 min at 80°C; and a to-be-sprayed substrate is obtained. A surface of the to-be-sprayed substrate is determined as a soldering surface, a part on which the soldering metal layer is not sprayed is masked, and then cold spraying of copper is performed: helium gas, the pressure is 2 MPa, the spraying distance is 30 mm, and the copper powder feed rate is 10 kg/h, to obtain the soldering metal layer whose thickness is 100 µm. The heat dissipation substrate is obtained.

Tests of soldering performance, anticorrosion performance, and bonding performance are performed on the heat dissipation substrate, and results are seen in Table 2.

### Embodiment 4

This embodiment describes a heat dissipation substrate of this disclosure and a method for preparing same.

An Al-SiC composite board (the thickness of SiC is 3 mm, and the thickness of Al is 500 µm) is immersed for 5 min in degreasing powder U-151 (Atotech) at 50°C to perform degreasing and dewaxing, and then immersed for 1 min at a room temperature in a tank liquid configured by hot-dipping electrolytic deterging powder U-152 to perform deoxidation, to obtain a to-be-oxidized substrate.

The to-be-oxidized substrate is placed in an oxidation solution containing 200 g/L of sulfuric acid (98 wt%), and anodic oxidation is performed for 5 min at 15°C, 10 V, and 2.5 A/cm³; an aluminum oxide layer whose thickness is 300 µm is obtained; then sealing is performed with purified water for 5 min at 95°C, and then for 30 min at 80°C; and a to-be-sprayed substrate is obtained.

A surface of the to-be-sprayed substrate is determined as a soldering surface, a part on which the soldering metal layer is not sprayed is masked, and then cold spraying of copper is performed: nitrogen gas, the pressure is 1.5 MPa, the spraying distance is 50 mm, and the copper powder feed rate is 3 kg/h, to obtain the soldering metal layer whose thickness is 1000 µm. The heat dissipation substrate is obtained.

Tests of soldering performance, anticorrosion performance, and bonding performance are performed on the heat dissipation substrate, and results are seen in Table 2.

### Embodiment 5

This embodiment describes a heat dissipation substrate of this disclosure and a method for preparing same.

An Al-SiC composite board (the thickness of SiC is 3 mm, and the thickness of Al is 350 µm) is immersed for 5 min in degreasing powder U-151 (Atotech) at 50°C to perform degreasing and dewaxing, and then immersed for 1 min at a room temperature in a tank liquid configured by hot-dipping electrolytic deterging powder U-152 to perform deoxidation, to obtain a to-be-oxidized substrate.

The to-be-oxidized substrate is placed in a chemical oxidation solution containing 60 ml/L of phosphoric acid and 25 g/L of chromic anhydride, chemical oxidation is performed for 5 min at 35°C, to obtain an aluminum oxide layer whose thickness is 200 µm; then the aluminum oxide layer is cleaned up and dried for 30 min at 80°C; and a to-be-sprayed substrate is obtained.

A surface of the to-be-sprayed substrate is determined as a soldering surface, a part on which the soldering metal layer is not sprayed is masked, and then cold spraying of copper is performed: nitrogen gas, the pressure is 3.5 MPa, the spraying distance is 10 mm, and the copper powder feed rate is 15 kg/h, to obtain the soldering metal layer whose thickness is 500 µm. The heat dissipation substrate is obtained.

Tests of soldering performance, anticorrosion performance, and bonding performance are performed on the heat dissipation substrate, and results are seen in Table 2.

### Comparison example 1

An Al-SiC composite board (the thickness of SiC is 3 mm, and the thickness of Al is 200 µm) is immersed in ERPREP Flex (Atotech) for 5 min at 50°C to perform degreasing and dewaxing, and then immersed for 3 min in a tank liquid configured by Actane 4322s to perform deoxidation; and a treated substrate is obtained.

Nickel plating is performed on the treated substrate according to a process shown in Table 1, to obtain a nickel layer whose thickness is 10 µm; and a heat dissipation substrate is obtained. Chemicals are products commercially available from Cookson-Enthone Chemistry.

**Table 1**

| Procedure | Chemical | Temperature | Time |
|---|---|---|---|
| Deterging | ENPLATE BS | Room temperature | 3 min |
| Water washing | Purified water | Room temperature | 1 min |
| Zinc galvanizing 1 | ENPLATE BS EN | Room temperature | 1 min |
| Water washing | Purified water | Room temperature | 1 min |
| Zinc stripping | 50% nitric acid | Room temperature | 1 min |
| Water washing | Purified water | Room temperature | 1 min |
| Zinc galvanizing 1 | ENPLATE BS EN | Room temperature | 30s |
| Water washing | Purified water | Room temperature | 1 min |
| Basic nickel | ENPLATE ENI-120 | Room temperature | 10 min |
| Water washing | Purified water | Room temperature | 1 min |
| Nickel plating | ENPLATE ENI-807 | 85°C | 60 min |
| Water washing | Purified water | Room temperature | 1 min |
| Drying | | 80°C | 30 min |

Tests of soldering performance, anticorrosion performance, and bonding performance are performed on the heat dissipation substrate, and results are seen in Table 2.

**Table 2**

| Number | Soldering performance | Anticorrosion performance | Bonding performance |
|---|---|---|---|
| Embodiment 1 | OK | 500h | 5B |
| Embodiment 2 | OK | 500h | 5B |
| Embodiment 3 | OK | 500h | 5B |
| Embodiment 4 | OK | 96h | 4B |
| Embodiment 5 | OK | 48h | 4B |
| Comparison example 1 | OK | 24h | 3B |

It may be seen from the embodiments, the comparison example, and data results in Table 2 that, the heat dissipation substrate provided in this disclosure may have good anticorrosion performance, soldering performance, and bonding performance at the same time. Moreover, the heat dissipation substrate provided in this disclosure has a simpler technology, is industrialized conveniently, and is reduced in use of nickel, costs and discharging of nickel liquid waste are reduced, and this disclosure provides the heat dissipation substrate with better performance in a more environmentally-friendly manner.

## Claims

1. A heat dissipation substrate, comprising:
a metal-ceramic composite board, wherein the metal-ceramic composite board is a metal layer wrapping a ceramic body;
a metal oxide layer integrated with the metal layer and formed on an outer surface of the metal layer; and
a soldering metal layer formed on at least a part of an outer surface of the metal oxide layer, wherein the soldering metal layer is used to connect with a copper substrate and bear a chip.

2. The substrate according to claim 1, wherein the metal oxide layer is formed by directly oxidizing the metal layer.

3. The substrate according to claim 1 or 2, wherein the ceramic body is selected from a SiC ceramic body or a Si ceramic body; the metal layer is an Al metal layer, an Mg metal layer, or a Ti metal layer; the metal oxide layer is an aluminum oxide layer, a magnesium oxide layer, or a titanium oxide layer; and the soldering metal layer is a copper metal layer or a nickel metal layer.

4. The substrate according to claim 1 or 2, wherein the thickness of the metal layer is 20 µm to 500 µm; the thickness of the metal oxide layer is 5 µm to 300 µm; and the thickness of the soldering metal layer is 20 µm to 1000 µm.

5. The substrate according to claim 1 or 2, wherein a bonding strength between the metal oxide layer and the metal layer is measured to be above 4B according to a cross-cut test.

6. A method for preparing the heat dissipation substrate according to any one of claims 1 to 5, comprising: directly performing metal oxidation on a metal-ceramic composite board, wherein the metal-ceramic composite board is a composite board material in which a metal layer wraps a ceramic body; forming a metal oxide layer integrated with the metal layer on an outer surface of the metal layer; and performing metal spraying on at least a part of an outer surface of the metal oxide layer, to form a soldering metal layer.

7. The method according to claim 6, wherein a method for the metal oxidation comprises chemical oxidation, anodic oxidation, micro-arc oxidation, or phosphatization.

8. The method according to claim 6 or 7, wherein a method for the metal spraying comprises:
cold spraying, plasma spraying, flame spraying, or sputtering.

9. The method according to claim 6 or 7, wherein the thickness of the metal oxide layer formed through the metal oxidation is 5 µm to 300 µm; and the thickness of the soldering metal layer formed through the metal spraying is 20 µm to 1000 µm.

10. An application of the heat dissipation substrate according to any one of claims 1 to 5 in an electronic device.

11. An electronic device, comprising:
a heat dissipation substrate, wherein the heat dissipation substrate has a soldering metal layer; and
a first soldering layer, a first copper substrate, a lining board, a second copper substrate, a second soldering layer, and a chip sequentially stacked on a surface of the soldering metal layer, wherein the chip is connected to the second copper substrate through a conducting wire; and
the heat dissipation substrate is the heat dissipation substrate according to any one of claims 1 to 5.
